Europäisches Patentamt

European Patent Office

Office européen des brevets

(19)

(11) Numéro de publication : **0 121 446**
**B1**

(12) **FASCICULE DE BREVET EUROPÉEN**

(45) Date de publication du fascicule du brevet :
**27.05.87**

(51) Int. Cl.⁴ : **H 03 F   1/32**

(21) Numéro de dépôt : **84400226.1**

(22) Date de dépôt : **02.02.84**

(54) **Dispositif de linéarisation d'amplificateur haute fréquence à coefficients de non-linéarité complexes.**

(30) Priorité : **11.02.83 FR 8302253**

(43) Date de publication de la demande :
**10.10.84 Bulletin 84/41**

(45) Mention de la délivrance du brevet :
**27.05.87 Bulletin 87/22**

(84) Etats contractants désignés :
**DE GB**

(56) Documents cités :
**EP-A- 0 085 600**
**DE-A- 2 306 294**
**US-A- 4 178 557**
**US-A- 4 243 955**
**US-A- 4 291 277**

(73) Titulaire : **THOMSON-CSF**
**173, Boulevard Haussmann**
**F-75379 Paris Cedex 08 (FR)**

(72) Inventeur : **Gaudin, Daniel**
**THOMSON-SCF SCPI 173, bld Haussmann**
**F-75379 Paris Cedex 08 (FR)**

(74) Mandataire : **El Manouni, Josiane et al**
**THOMSON-CSF SCPI 19, avenue de Messine**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

La présente invention concerne un dispositif de linéarisation d'amplificateur haute fréquence à coefficients de non-linéarité complexes et destiné à amplifier un signal multitons.

La non-linéarité d'un amplificateur provoque l'apparition de signaux parasites appelés produits d'intermodulation, lorsqu'il est excité simultanément par plusieurs signaux dont les fréquences sont différentes. Lorsque les signaux haute fréquence à amplifier sont proches les uns des autres, par exemple dans le cas de signaux modulés, le phénomène d'intermodulation se traduit alors en dehors de la bande de modulation par une perturbation des communications utilisant des canaux voisins et dans la bande de modulation par une distorsion phonique et surtout par un accroissement du taux d'erreur en cas de transmission numérique multiporteuse.

Pour éviter de pareils effets il convient de minimiser les conséquences du phénomène de non-linéarité. Diverses solutions ont été proposées pour cela. Elles peuvent se classer en deux catégories : les dispositifs à asservissement permanent et les dispositifs précorrecteurs.

Ces deux méthodes consistent à appliquer à l'entrée de l'amplificateur haute fréquence non pas directement le signal e(t) à amplifier, mais un signal h(t) obtenu à partir du signal à amplifier et dont le spectre comporte, outre les raies haute fréquence du signal à amplifier, des raies correctrices situées aux fréquences des produits d'intermodulation à éliminer.

Lorsque les coefficients de non-linéarité de l'amplificateur sont complexes, il est connu d'obtenir les raies correctrices en agissant séparément sur le module et la phase du signal de sortie s(t) de l'amplificateur. il est par exemple connu d'asservir indépendamment et séparément l'enveloppe (atténuée) et la phase du signal s(t) à l'enveloppe et à la phase du signal e(t).

Il est par ailleurs connu, d'après la demande de brevet français n° 82 01 454 (correspondant à la demande EP 85 600 déposée le 29-1-82 et publiée le 10-8-83), déposée au nom de la demanderesse, d'obtenir les raies correctrices par précorrection en agissant indépendamment et séparément sur deux paramètres distincts du signal s(t).

Le dispositif de linéarisation décrit dans cette demande de brevet comporte en effet des moyens pour élaborer par précorrection, à partir du signal haute fréquence à amplifier, un premier un second signal de correction dont le spectre comporte des raies d'amplitude réglable situées à des fréquences correspondant aux harmoniques des écarts de tons du signal haute fréquence à amplifier, agissant séparément sur deux paramètres distincts du signal à amplifier, et un dispositif de prédistorsion pour élaborer à partir du signal haute fréquence à amplifier et des premier et second signaux de correction, un signal d'entrée de l'amplificateur dont le spectre comporte, outre les raies haute fréquence du signal à amplifier, des raies correctrices, aux fréquences des produits d'intermodulation d'ordres impairs, d'amplitude réglable par action conjointe sur les réglages d'amplitude des raies du spectre du premier et du second signal de correction, ces réglages étant effectués en vue d'obtenir une annulation des produits d'intermodulation d'ordres impairs situés au voisinage de la bande d'émission dans le signal amplifié.

Par ailleurs, dans la demande de brevet n° 82 01 454 précitée, un dispositif de prédistorsion particulier a été décrit, comportant un modulateur de phase et un modulateur d'amplitude destinés respectivement à moduler le signal à amplifier par le premier et le second signal de correction.

La présente demande de brevet a pour objet un nouveau dispositif de prédistorsion présentant intrinséquement, une mise en œuvre facilitée par rapport à celui décrit dans la demande de brevet précitée, et, en association avec des moyens pour obtenir les signaux q(t) et q'(t) conformes à un second objet de l'invention, une mise en œuvre simplifiée du dispositif de linéarisation.

Suivant l'invention, le dispositif de linéarisation d'amplificateur de signaux haute fréquence, à coefficients de non-linéarité complexes, et destiné à amplifier un signal multitons e(t), comportant des moyens pour élaborer, à partir du signal haute fréquence à amplifier, un premier et un second signal de correction q(t) et q'(t) dont le spectre comporte des raies d'amplitude réglable situées à des fréquences correspondant aux harmoniques des écarts de tons du signal haute fréquence à amplifier, agissant séparément sur deux paramètres distincts du signal à amplifier, et un dispositif de prédistorsion pour élaborer à partir du signal haute fréquence à amplifier et des premier et second signaux de correction un signal d'entrée h(t) de l'amplificateur dont le spectre comporte, outre les raies haute fréquence du signal à amplifier, des raies correctrices, aux fréquences des produits d'intermodulation d'ordres impairs, d'amplitude réglable par action conjointe sur les réglages d'amplitude des raies du spectre du premier et du second signal de correction q(t) et q"(t), ces réglages étant effectués en vue d'obtenir une annulation des produits d'intermodulation d'ordres impairs situés au voisinage de la bande d'émission dans le signal amplifié, ce dispositif de linéarisation est tel que le dispositif de prédistorsion comporte un modulateur d'amplitude du signal à amplifier e(t) par le premier signal de correction q(t), un modulateur d'amplitude à suppression de porteuse, du signal à amplifier e(t) déphasé de $\Pi/2$, par le second signal de correction q'(t), et un sommateur des signaux issus de ces deux modulateurs, fournissant le signal d'entrée de l'amplificateur.

Suivant un autre objet de la présente invention, le premier et le second signal de correction sont obtenus respectivement par asservissement de deux paramètres particuliers du signal s(t) qui sont sa composante provenant de la partie réelle de la fonction de transfert de l'amplificateur et sa composante provenant de la partie imaginaire de la fonction de transfert de l'amplificateur (appelées aussi par la suite reflets de l'amplitude de deux composantes réelles orthogonales du signal amplifié, ou plus simplement composantes X et Y du signal s(t)), aux composantes correspondantes du signal à amplifier.

L'invention sera mieux comprise au cours de la description qui suit et à l'examen des figures qui la soutiennent ; celles-ci sont données à titre indicatif et non limitatif des caractéristiques de l'invention ; elles représentent :

figures 1a à 1d, les diagrammes de la fonction de transfert d'un amplificateur HF à linéariser ;

figure 2, l'allure du signal d'entrée de cet amplificateur et de son enveloppe pour une excitation à deux tons égaux ;

figures 3a et 3b, le spectre total filtré du signal de sortie de cet amplificateur ;

figure 4a, un schéma fonctionnel du dispositf de prédistorsion conforme à l'invention, les figures 4b, 4c et 4d en représentant des variantes ;

figure 5, un schéma fonctionnel d'un dispositif de linéarisation par précorrection obtenu par application au dispositif de prédistorsion conforme à l'invention, de signaux de correction obtenus par traitement de l'enveloppe du signal à amplifier ;

figure 6, un schéma fonctionnel d'un dispositif de linéarisation par asservissement obtenu par application au dispositif de prédistorsion conforme à l'invention, de signaux de correction provenant des comparaisons de l'amplitude et de la phase du signal amplifié s(t) avec l'amplitude et la phase du signal à amplifier e(t) ;

figure 7, un schéma fonctionnel d'un dispositif de linéarisation par asservissement obtenu par application au dispositif de prédistorsion conforme à l'invention, de signaux de correction obtenus conformément à l'invention par comparaison de deux paramètres qui sont les reflets de l'amplitude de deux composantes réelles orthogonales du signal amplifié, aux composantes correspondantes du signal à amplifier.

Des éléments identiques sur des figures distinctes portent les mêmes références.

On considère un amplificateur haute fréquence recevant un signal e(t) à l'entrée et délivrant un signal S(t) à la sorti. S(t) peut s'écrire :

$$S(t) = X(e(t)) + j\ Y(e(t))$$

dans lequel X et Y sont des fonctions réelles et j est le nombre imaginaire tel que $j^2 - 1$.

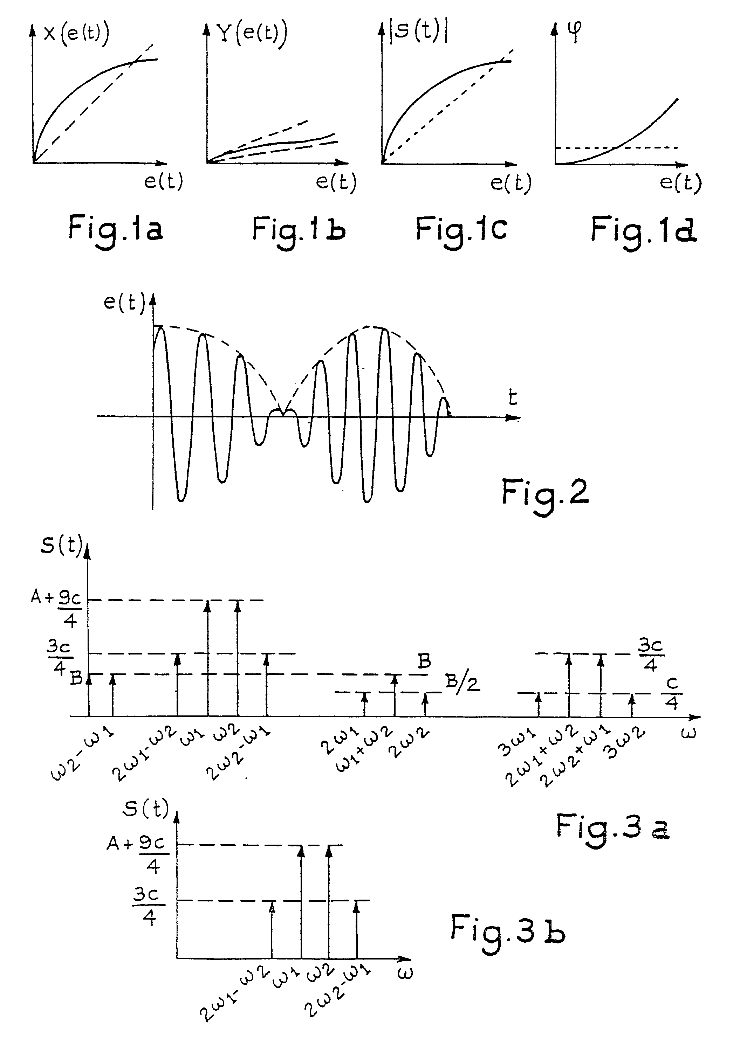

Les figures 1a et 1b montrent que l'amplificateur haute fréquence n'est pas linéaire ; en particulier X(e(t)) n'est pas proportionnel à e(t), et présente une légère saturation par exemple. Le module du signal de sortie peut être représenté par :

$$|\,S(t)\,| = \sqrt{X^2 + Y^2} \cdot e$$

Le diagramme de ce module apparaît sur la figure 1c. le déphasage du signal de sortie par rapport au signal d'entrée,

$$\phi(S/e) = \text{Arctg } (Y/X)$$

est représenté sur la figure 1d. En pointillés apparaissent sur ces diagrammes les caractéristiques de transfert d'un amplificateur idéal. Le signal e(t), amplifié par un tel amplificateur, subira donc des déformations lors de l'amplification. Ces déformations peuvent être explicitées en décomposant le signal S(t) selon le polynôme de transfert. Suivant une telle décomposition S(t) s'écrit :

$$S(t) = A\ e(t) + B\ e^2(t) + C\ e^3(t) + \ldots$$

dans laquelle A, B, C sont des nombres complexes tels que :

$$A = a + ja' \quad \text{avec} \quad |A| = \sqrt{a^2 + a'^2}$$

$$B = b + jb' \quad \text{avec} \quad |B| = \sqrt{b^2 + b'^2}$$

$$C = c + jc' \quad \text{avec} \quad |C| = \sqrt{c^2 + c'^2}$$

A, B, C... caractérisant les défauts de linéarité de l'amplificateur. Il est bon de remarquer que généralement leur module va décroissant lorsqu'ils pondèrent le signal d'entrée e(t) élevé à une puissance de plus en plus élevée. On indiquera par la suite comment cette décomposition permet de mettre en évidence que le défaut de linéarité de l'amplificateur provoque la naissance de produits d'intermodulation gênants. mais par ailleurs l'étude montrera qu'il n'est pas nécessaire de connaître la fonction de transfert de l'amplificateur que l'on cherche à corriger et que donc un dispositif selon la présente invention présente à cet effet un caractère universel. En effet. après traitement par le dispositif de linéarisation de l'invention, dans le signal final les termes X, Y, A, B, C, caractéristiques de l'amplificateur auront disparu pour être remplacés par une caractéristique de la forme $S(t) = X'(e(t)) + jY'(e(t))$, $X'$ et $Y'$ étant linéaires, c'est-à-dire $X'(e(t))/e(t) = $ constante et $Y'(e(t))/e(t) = $ constante. Alors $\phi(S/e) = $ constante. En réalité si l'amplificateur dispose en sortie d'un filtre harmonique l'action de celui-ci est incorporée dans l'expression précédente de $S(t)$.

Lorsque le signal $e(t)$ ne comporte qu'un ton haute fréquence, la non-linéarité ne provoque que des raies harmoniques dont l'amplitude selon le rang est liée à la valeur des coefficients A, B, C, ... Elles peuvent être éliminées aisément par filtrage. Par contre si le signal $e(t)$ comporte au moins deux tons il en va tout autrement et certaines raies parasites tombent en des zones de fréquence intermédiaires aux deux tons. Si les deux tons sont proches l'un de l'autre on ne saura pas effectuer facilement le filtrage de ces produits d'intermodulation parasites.

L'étude qui suit est faite pour un signal d'entrée $e(t)$ comportant deux tons égaux selon la méthode recommandée par le CCIR mais le principe reste valable pour deux tons inégaux ou pour n tons quelconques, même émis à des amplitudes différentes. Le signal $e(t)$, à deux tons égaux par exemple, introduit à l'entrée de l'amplificateur à corriger aura la forme :

$$e(t) = V(\cos w_1 t + \cos w_2 t)$$

ce qui peut s'écrire également

$$e(t) = 2V \cos (w_2 - w_1/2) t \cdot \cos (w_2 + w_1/2) t .$$

Dans cette expression $w_1$ et $w_2$ sont les pulsations de chacun des deux tons.

Dans un exemple l'amplificateur à corriger sera un amplificateur pour signaux BLU émis dans la bande 1,5 à 30 MHz. Les pulsations $w_1$, $w_2$, correspondant aux deux tons évoqués, correspondront à des fréquences situées dans cette bande et distantes l'une de l'autre d'environ 3 kHz par exemple. Ces grandeurs ne sont bien entendu nullement restrictives du champ d'application de l'invention.

Un tel signal $e(t)$ est visible sur la figure 2. Sur cette figure on distingue le signal $e(t)$ proprement dit constitué par les alternances resserées en traits pleins. Selon la deuxième partie de l'expression de $e(t)$ indiquée précédemment il apparaît que $e(t)$ est équivalent au produit d'un premier signal de pulsation $(w_1 + w_2)/2$ par un second signal de pulsation $(w_2 - w_1)/2$ (de basse fréquence).

En remplaçant, dans la décomposition polynômiale de $S(t)$, $e(t)$ par la valeur conventionnelle à deux tons que l'on vient de déterminer, $S(t)$ s'écrit, une fois tous calculs faits :

$$
\begin{aligned}
S(t) = {} & B + B(\cos (w_1 - w_2)t + \cos (w_1 + w_2)t) \\[6pt]
& + (A + \frac{9C}{4}) (\cos w_1 . t + \cos w_2 . t) \\[6pt]
& + (\frac{3C}{4}) (\cos(2w_1 - w_2)t + \cos (2w_2 - w_1)t) \\[6pt]
& + (\frac{B}{2}) (\cos 2w_1 . t + \cos 2w_2 . t) \\[6pt]
& + \frac{3C}{4} (\cos (2w_1 + w_2)t + \cos (2w_2 + w_1)t) \\[6pt]
& + \frac{C}{4} (\cos 3w_1 . t + \cos 3w_2 . t) \\[6pt]
& + ....
\end{aligned}
$$

Pour simplifier les calculs, on s'est arrêté aux non-linéarités d'ordre 3, mais l'articulation de ces calculs reste valable pour tout ordre plus élevé.

Une représentation spectrale de $S(t)$ est donnée sur la figure 3a. Cette figure représente le spectre total de $S(t)$. Comme $(w_1 + w_2)/2$ est très supérieur à $w_2 - w_1$ on constate que ce spectre présente des groupements de raies autour de pulsations ayant la valeur de :

$$w = n(w_1 + w_2)/2$$

n entier compris entre 0 et l'infini.

Les amplitudes des différentes raies, apparaissant sur ce spectre total, sont celles données en fonction des paramètres A, B, C de la décomposition polynômiales de $S(t)$. Seul le module des coefficients figurant en ordonnée est à prendre en compte. On remarquera que seul le groupement situé autour de la pulsation $(w_1 + w_2)/2$ nous intéresse. Il est gênant, car il comporte des raies aux pulsations

4

$2w_1 - w_2$ ou $2w_2 - w_1$. Par un dispositif connu de l'art antérieur on éliminera par ailleurs facilement les harmoniques situées hors de cette bande utile. En effet les matériels d'émission conventionnels disposent en sortie de filtres harmoniques ne laissant pas non plus passer ni les composantes continues ni la basse fréquence ($w_2 - w_1$).

Le spectre du signal amplifié dans la bande utile est représenté sur la figure 3b. On constate qu'il comporte des raies aux pulsations $w_1$ et $w_2$ pondérées chacune par le même coefficient $A + (9C/4)$ signifiant ainsi que chaque raie a subi une amplification égale. Il comporte également les deux raies parasites d'intermodulation $2w_1 - w_2$, $2w_2 - w_1$ chacune affectée du coefficient $3C/4$. On remarquera que ne sont pas représentées sur la figure 3b les amplitudes des raies d'intermodulation de cinquième ordre de la forme $3w_1 - 2w_2$ et $3w_2 - 2w_1$. D'une part les coefficients affectant chacune de ces raies sont en général inférieurs aux coefficients ayant affecté les raies d'intermodulation du troisième ordre et d'autre part on verra par la suite que ces raies d'intermodulation subiront le même traitement que les premières et seront également annihilées. Leur représentation aurait alourdi les représentations de la figure 3.

On a vu que les termes pairs n'avaient pas d'incidence sur les produits d'intermodulation qui nous préoccupent. Pour poursuivre les calculs, on ne va donc pas s'encombrer des non-linéarités d'ordre pair, et on va aller jusqu'à l'ordre 5 par les non-linéarités d'ordre impair :

$$S(t) = A\,e(t) + C\,e^3(t) + E\,e^5(t)$$

En redonnant au polynôme le caractère complexe évoqué précédemment ($A = a + ja'$, $C = c + jc'$ et $E = e + je'$), tous calculs faits, $S(t)$ prend la forme suivante après filtrage harmonique :

$$
\begin{aligned}
S(t) = \ & \left(aV + \frac{9c}{4}V^3 + \frac{50eV^5}{8}\right) && (\cos w_1 t + \cos w_2 t) \\
& + \left(a'V + \frac{9c'}{4}V^3 + \frac{50e'V^5}{8}\right) && \left(\cos\left(w_1 t + \frac{\Pi}{2}\right) + \cos\left(w_2 t + \frac{\Pi}{2}\right)\right) \\
& + \left(\frac{3}{4}cV^3 + \frac{25}{8}eV^5\right) && \left(\cos(2w_1 - w_2)t + \cos(2w_2 - w_1)t\right) \\
& + \left(\frac{3}{4}c'V^3 + \frac{25}{8}e'V^5\right) && \left(\cos\left((2w_1 - w_2)t + \frac{\Pi}{2}\right) + \cos\left((2w_2 - w_1)t + \frac{\Pi}{2}\right)\right) \\
& + \left(\frac{5e}{8}V^5\right) && \left(\cos(3w_1 - 2w_2)t + \cos(3w_2 - 2w_1)t\right) \\
& + \left(\frac{5e'}{8}V^5\right) && \left(\cos\left((3w_1 - 2w_2)t + \frac{\Pi}{2}\right) + \cos\left((3w_2 - 2w_1)t + \frac{\Pi}{2}\right)\right)
\end{aligned}
$$

Cette écriture fait apparaître chaque raie du spectre de $S(t)$ avec filtrage harmonique, selon deux composantes réelles orthogonales, l'une provenant de la partie réelle des coefficients de non-linéarité, l'autre, déphasée de $\Pi/2$ radians, provenant de la partie imaginaire de ces mêmes coefficients.

Ces composantes sont conformes d'une part à une modulation d'amplitude de $e(t)$ laissant passer également les raies principales et d'autre part à une seconde modulation de $e(t)$, soit de phase à faible indice, soit d'amplitude sans porteuse (modulation DBL, équilibrée) et déphasée de $\Pi/2$ radians ajoutée à la première. A partir de cette observation il est possible donc de créer des raies opposées aux raies d'intermodulation, par addition d'une modulation d'amplitude de $e(t)$ par un premier signal de correction $q(t)$ adéquat et d'une modulation d'amplitude sans porteuse, de $e(t)$ déphasé au préalable de $\Pi/2$ radians, et ceci par un second signal de correction $q'(t)$ adéquat.

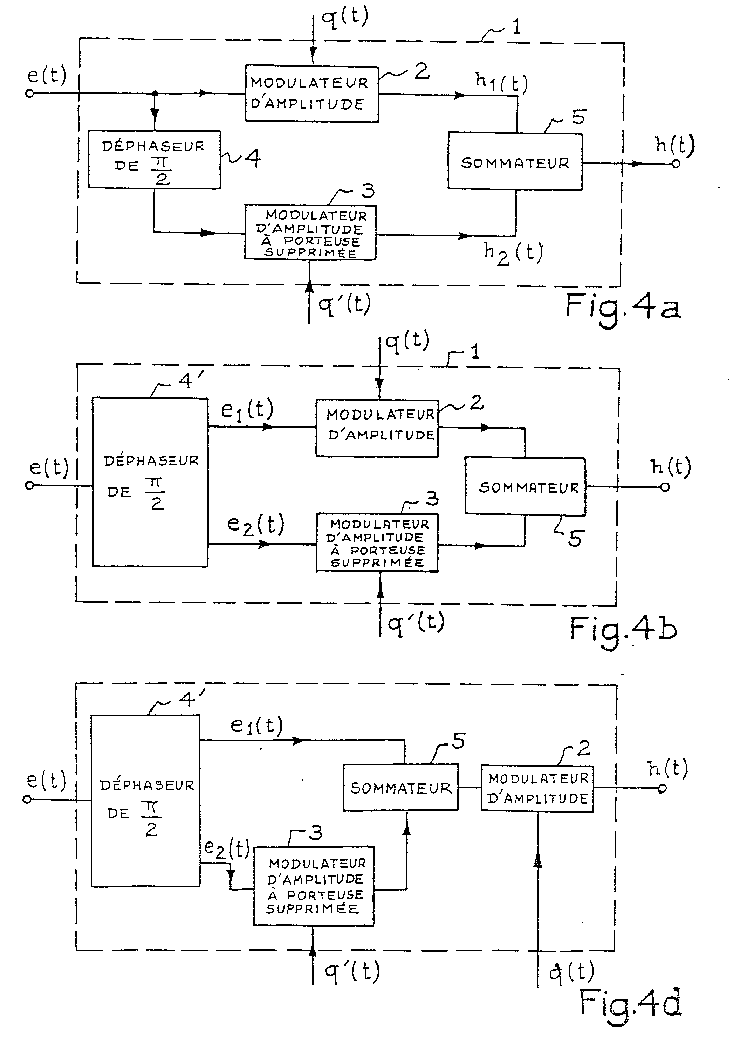

C'est pourquoi le dispositif de prédistorsion 1 conforme à l'invention, représenté sur la figure 4a, comporte un modulateur d'amplitude 2 qui reçoit les signaux $e(t)$ et $q(t)$, un modulateur d'amplitude à suppression de porteuse 3, qui reçoit le signal $e(t)$ déphasé de $\Pi/2$ au moyen d'un déphaseur 4, et un sommateur 5 qui reçoit des signaux $h_2(t)$ et $h_2(t)$ issus respectivement des modulateurs 2 et 3 et qui fournit le signal $h(t)$ appliqué à l'entrée de l'amplificateur.

Le modulateur d'amplitude à suppression de porteuse 3 est par exemple constitué par un modulateur équilibré, un modulateur en anneau, un multiplieur, un amplificateur à gain variable ou tout autre circuit équivalent.

Dans la pratique, si l'on souhaite travailler sur une bande assez large on utilisera comme le montre la figure 4b, à la place du déphaseur 4 de $\Pi/2$, un circuit 4' connu de l'art antérieur utilisant des quadripôles passe-tout, délivrant en deux sorties des signaux $e_1(t)$ et $e_2(t)$ déphasés de $\Pi/2$ radians entre eux mais de phase variable par rapport à l'entrée. Le caractère variable de la phase est absolument secondaire dans le cadre de l'invention puisque ce déphasage reste constant sur l'étroit spectre à transmettre (quelques kilohertz). La précision et la constance de l'écart de phase de $\Pi/2$ radians entre $e_1(t)$ et $e_2(t)$ dépend de l'ordre des circuits passe-tout.

5

Pour

$$e(t) = \sqrt{2}V \left( \cos (w_1 t - \phi(f)) + \cos (w_2 t - \phi(f)) \right)$$

$$e_1(t) = V \left( \cos w_1 t + \cos w_2 t \right)$$

on a

$$e_2(t) = V \left( \cos (w_1 t + \frac{\pi}{2}) + \cos (w_2 t + \frac{\pi}{2}) \right)$$

Egalement sur le plan pratique, comme les raies principales doivent transiter par le modulateur d'amplitude 2 (ou amplificateur à gain variable) on favorisera le passage dans cette branche en utilisant un déphaseur asymétrique, favorisant la sortie 0° et laissant la sortie $\pi/2$ à — 10 ou — 15 dB. De même la sommation peut être réalisée au moyen d'un sommateur également asymétrique, par exemple un coupleur large bande 10 ou 15 dB, en utilisant la voie couplée comme entrée de la branche déphasée de $\pi/2$. En effet cela permet en modulant fortement la voie déphasée d'obtenir en sortie une équivalence des raies de modulation à 10 ou 30 dB des raies principales, ce qui est dans la majorité des cas largement suffisant.

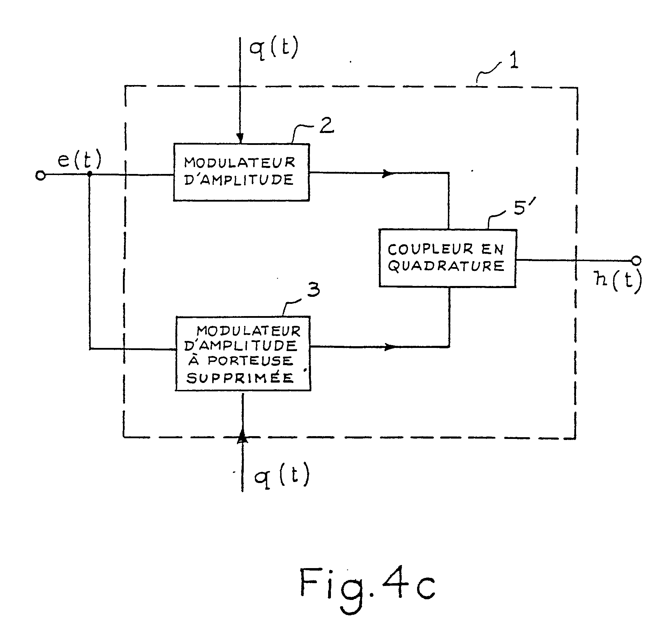

La figure 4c représente une variante de réalisation des figures 4a et 4b, dans laquelle les modulateurs 2 et 3 reçoivent tous les deux le signal à amplifier e(t), le déphasage de $\pi/2$ entre les raies issues respectivement des modulateurs 2 et 3 étant alors obtenu au moyen d'un coupleur en quadrature 5' qui remplace le sommateur 5. Le coupleur 5' apportant un déphasage (variable avec la fréquence) aux raies issues des modulateurs 2 et 3, il est nécessaire de tenir compte de ce déphasage dans le cas où les signaux q(t) et q'(t) sont obtenus par contre-réaction.

Une variante de réalisation est également donnée en figure 4d où le modulateur d'amplitude 2 est placé après le sommateur 5, ce qui ajoute aux raies de modulation déphasées de $\pi/2$ une légère modulation qui est parfaitement négligeable.

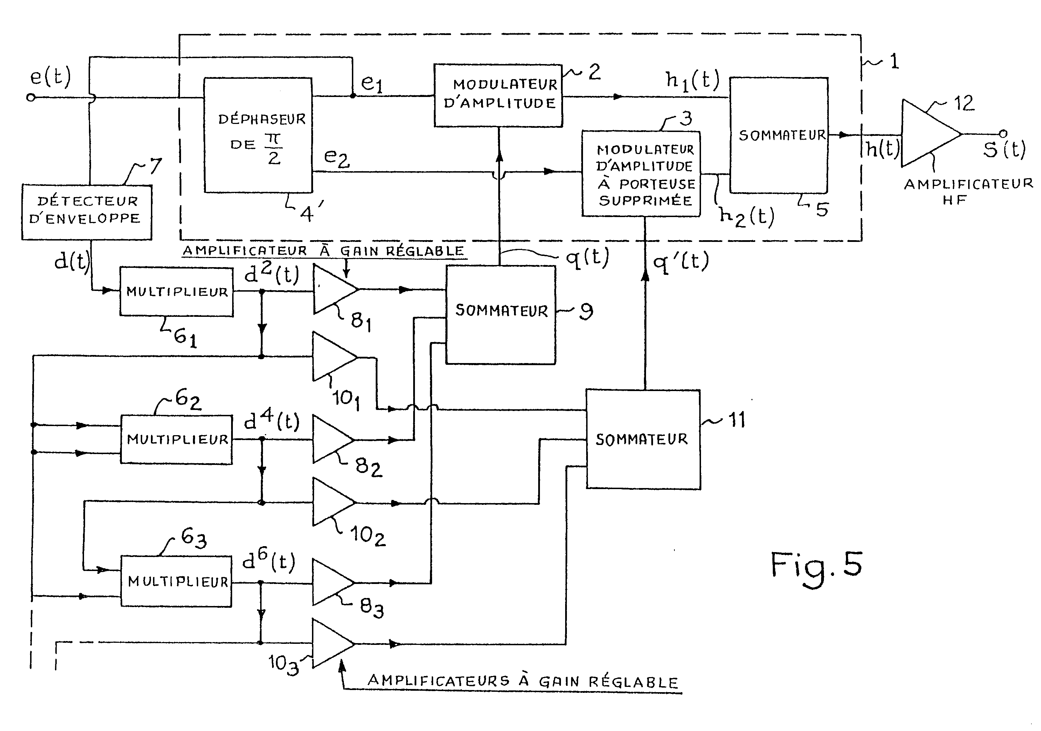

Le dispositif de prédistorsion représenté sur les figures 4a, 4b, 4c et 4d représente une mise en œuvre simplifiée du fait de l'utilisation exclusive de modulateurs d'amplitude. Son fonctionnement sera exposé en même temps que celui des moyens pour obtenir les signaux de correction q(t) et q'(t), suivant les diverses réalisations données aux figures 5, 6 et 7.

Les signaux de correction q(t) et q'(t) peuvent être obtenus soit par précorrection soit par asservissements paramétrés.

Sur la figure 5 on a représenté le dispositif de prédistorsion 1 conforme à l'invention (par exemple conforme au schéma de la figure 4b) auquel sont appliqués des signaux q(t) et q'(t) obtenus par traitement de l'enveloppe du signal à amplifier, conformément au dispositif décrit dans la demande de brevet n° 82 01 454 déposée au nom de la demanderesse, réduisant l'intermodulation par précorrection du signal à amplifier.

Le signal q(t) est obtenu au moyen de N multiplieurs $6_1$, $6_2$, $6_3$, ..., $6_N$ dont le premier $6_1$ est muni de deux entrées reliées à la sortie d'un détecteur d'enveloppe 7 du signal e(t), dont le deuxième $6_2$ est muni de deux entrées reliées à la sortie du premier et dont le $n^{ième}$ $6_n$ (n étant un entier compris entre 3 et N) est muni de deux entrées reliées respectivement à la sortie du premier et du $(n-1)^{ième}$, de N amplificateurs linéaires $8_n$ à gain réglable en amplitude et en signe, munis chacun d'une entrée reliée à la sortie de l'un des N multiplieurs $6_n$, et d'un sommateur 9 muni de N entrées, reliées aux sorties des N amplificateurs à gain réglable $8_n$ et d'une sortie qui fournit le signal q(t).

De même le signal q'(t) est obtenu au moyen des N multiplieurs $6_n$, de N amplificateurs linéaires $10_n$ à gain réglable en amplitude et en signe, munis chacun d'une entrée reliée à la sortie de l'un des N multiplieurs $6_n$ et d'un sommateur 11 muni de N entrées reliées aux sorties des N amplificateurs réglables $10_n$ et d'une sortie qui fournit le signal q'(t).

Sur la figure 5 on a également représenté l'amplificateur haute fréquence 12 à linéariser, auquel est appliqué le signal h(t) issu du dispositif de prédistorsion 1.

Le dispositif de linéarisation représenté sur la figure 5 fonctionne de la façon suivante :

Pour $e_1(t) = V(\cos w_1 t + \cos w_2 t)$, on a :

$$q(t) = 2 k_1 V^2 + 6 k_2 V^4 + 1$$
$$+ (2 k_1 V^2 + 8 k_2 V^4) \cos (w_2 - w_1)t$$
$$+ 2 k_2 V^4 \cos 2 (w_2 - w_1)t$$

les coefficients $k_1$, $k_2$, ...., etc. représentent le gain des amplificateurs $8_n$ à gain réglable algébriquement par l'opérateur et le terme + 1 caractérisant la modulation d'amplitude à partir d'un étage à gain variable, auquel cas il est extérieur et l'étage modulateur ne fait qu'une multiplication de e(t) par q(t) pour donner

$$h_1(t) = e_1(t) \cdot q(t)$$

$$
\begin{aligned}
h_1(t) = \ & (V + 3 k_1 V^3 + 10 k_2 V^5)(\cos w_1 t + \cos w_2 t) \\
& + (k_1 V^3 + 5 k_2 V^5)(\cos (2w_1 - w_2)t + \cos (2w_2 - w_1)t) \\
& + k_2 V^5 (\cos (3w_1 - 2w_2)t + \cos (3w_2 - 2w_1)t)
\end{aligned}
$$

De même :

$$
\begin{aligned}
q'(t) = \ & 2 k'_1 V^2 + 6 k'_2 V^4 \\
& + (2 k'_1 V^2 + 8 k'_2 V^4) \quad \cos (w_2 - w_1)t \\
& + 2 k'_2 V^4 \quad\quad\quad\quad \cos 2(w_2 - w_1)t
\end{aligned}
$$

où $k'_1$, $k'_2$, ...., etc. représentent le gain des amplificateurs $10_n$ à gain réglable algébriquement par l'opérateur (ici il s'agit d'une modulation sans transmission de raies principales. On ne voit donc pas apparaître de terme $+ 1$).

$$h_2(t) = e_2(t) \cdot q'(t)$$

$$
\begin{aligned}
h_2(t) = \ & (3 k'_1 V^3 + 10 k'_2 V^5)(\cos (w_1 t + \tfrac{\Pi}{2}) + \cos (w_2 t + \tfrac{\Pi}{2})) \\
& + (k'_1 V^3 + 5 k'_2 V^5)(\cos ((2w_1 - w_2)t + \tfrac{\Pi}{2}) + \cos ((2w_2 - w_1)t + \tfrac{\Pi}{2})) \\
& + (k'_2 V^5)(\cos ((3w_1 - 2w_2)t + \tfrac{\Pi}{2}) + \cos ((3w_2 - 2w_1)t + \tfrac{\Pi}{2}))
\end{aligned}
$$

Le signal $h(t) = h_1(t) + h_2(t)$ traverse l'amplificateur 12 dont les non-linéarités affectent pratiquement uniquement les deux raies principales, compte tenu des niveaux. Dans ces conditions le signal de sortie $S(t)$ a pour expression :

$$
\begin{aligned}
S(t) = \ & ((aV + \tfrac{9cV^3}{4} + \tfrac{50eV^5}{8}) + a(3k_1 V^3 + 10 k_2 V^5))(\cos w_1 t + \cos w_2 t) \\
& + ((a'V + \tfrac{9c'V^3}{4} + \tfrac{50e'V^5}{8}) + a(3k'_1 V^3 + 10 k'_2 V^5))((\cos (w_1 t + \tfrac{\Pi}{2}) \\
& \quad\quad\quad\quad\quad\quad\quad\quad\quad\quad\quad\quad\quad\quad + \cos (w_2 t + \tfrac{\Pi}{2})) \\
& + ((\tfrac{3cV^3}{4} + \tfrac{25eV^5}{8}) + a(k_1 V^3 + 5 k_2 V^5))(\cos (2w_1 - w_2)t + \cos (2w_2 - w_1)t) \\
& + ((\tfrac{3c'V^3}{4} + \tfrac{25e'V^5}{8}) + a(k'_1 V^3 + 5 k'_2 V^5))(\cos ((2w_1 - w_2)t + \tfrac{\Pi}{2}) \\
& \quad\quad\quad\quad\quad\quad\quad\quad\quad\quad\quad\quad\quad\quad + \cos ((2w_2 - w_1)t + \tfrac{\Pi}{2})) \\
& + (\tfrac{5eV^5}{8} + a k_2 V^5)(\cos (3w_1 - 2w_2)t + \cos (3w_2 - 2w_1)t) \\
& + (\tfrac{5e'V^5}{8} + a k'_2 V^5)(\cos ((3w_1 - 2w_2)t + \tfrac{\Pi}{2}) + \cos ((3w_2 - 2w_1)t + \tfrac{\Pi}{2}))
\end{aligned}
$$

En commençant le réglage par les raies d'ordre le plus élevé on obtient

pour
$$k_2 = -\tfrac{5}{8} \tfrac{e}{a}, \ k'_2 = -\tfrac{5}{8} \tfrac{e'}{a}, \ k_1 = -\tfrac{3}{4} \tfrac{c}{a}, \ \text{et} \ k'_1 = -\tfrac{3}{4} \tfrac{c'}{a} :$$

$$
\begin{aligned}
S(t) = \ & aV (\cos w_1 t + \cos w_2 t) \\
& + a'V (\cos (w_1 t + \tfrac{\Pi}{2}) + \cos (w_2 t + \tfrac{\Pi}{2}))
\end{aligned}
$$

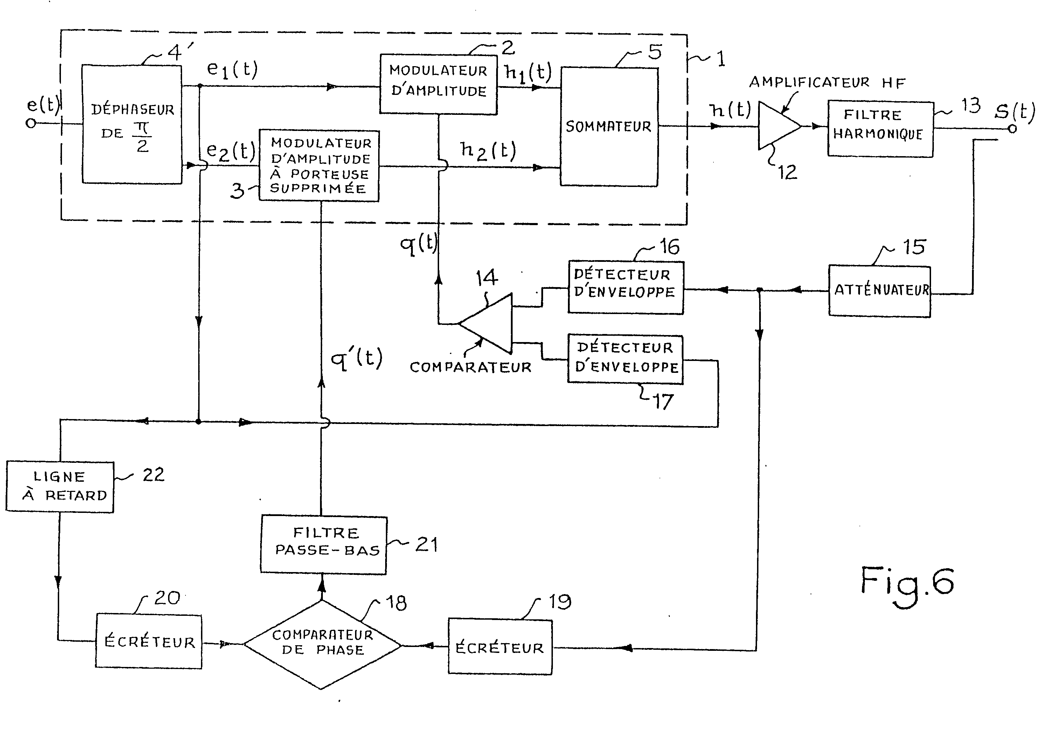

Sur la figure 6 on a représenté le dispositif de prédistorsion conforme à la figure 4b, auquel sont appliqués des signaux q(t) et q'(t) travaillant par asservissement de l'amplitude et de la phase du signal amplifié sur l'amplitude et la phase du signal à amplifier. On a également représenté sur cette figure les filtres harmoniques 13 disposés en sortie de l'amplificateur haute fréquence 12.

Suivant l'art connu, le signal q(t) est obtenu en sortie d'un comparateur 14 qui compare l'enveloppe des signaux S(t), atténué au moyen d'un atténuateur 15, et $e_1(t)$, détectée respectivement au moyen de deux détecteurs d'enveloppe 16 et 17.

De même le signal q'(t) est obtenu en sortie d'un comparateur de phase 18 qui compare la phase des signaux S(t) et $e_1(t)$ passés respectivement dans des écréteurs 19 et 20, le comparateur de phase 18 étant suivi d'un filtre passe-bas 21, et une ligne à retard 22 étant disposée sur le trajet de $e_1(t)$.

Le fonctionnement par asservissement sur le module et la phase étant bien connu, on ne le rappellera pas de manière plus détaillée.

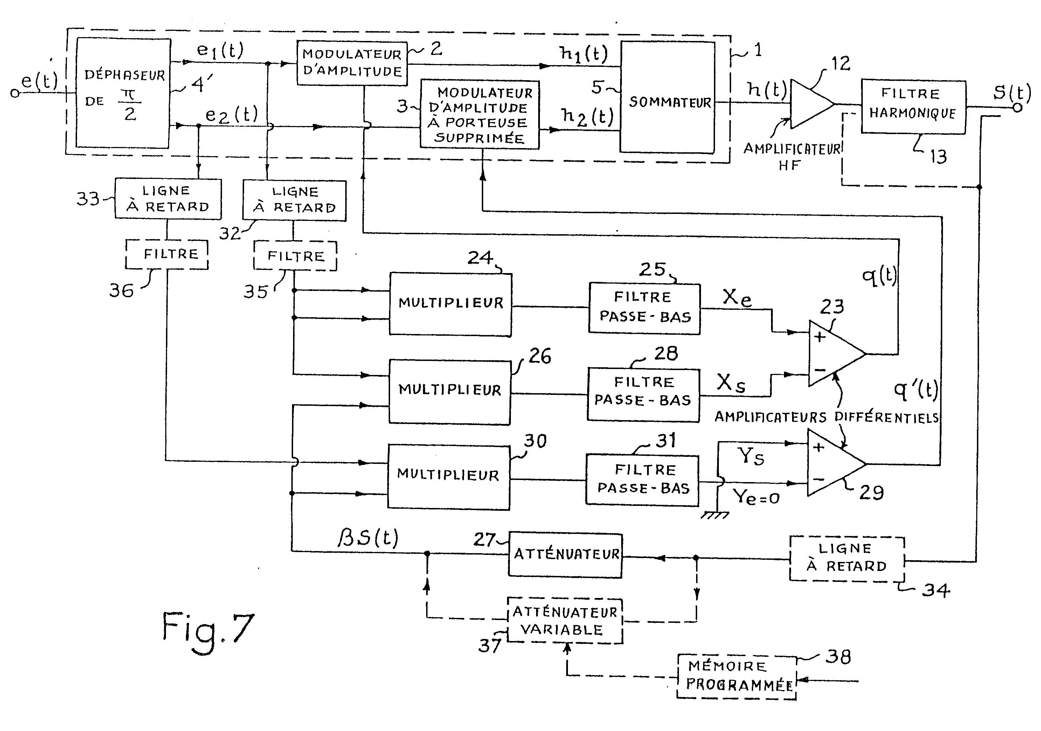

Sur la figure 7, on a représenté le dispositif de prédistorsion conforme à la figure 4b, auquel sont appliqués des signaux q(t) et q'(t) obtenus, conformément à l'invention, par comparaison de signaux BF et continus ($X_S$ et $Y_S$) représentatifs de l'amplitude du signal amplifié selon deux composantes réelles orthogonales dont l'une est en phase avec le signal à amplifier, avec des signaux analogues ($X_e$ et $Y_e$) représentatifs du signal à amplifier.

On expose tout d'abord le principe de cet asservissement.

Soit un signal d'entrée :

$$e_1(t) = V \cos wt$$

Après passage dans un amplificateur linéaire de gain G apportant un déphasage constant $\phi$, on obtient :

$$S(t) = GV \cos (wt + \phi)$$

On élève le signal d'entrée au carré :

$$e^2_1(t) = (V^2/2) (1 + \cos 2 wt)$$

Après filtrage passe-bas éliminant les termes HF, il reste :

$$X_e = V^2/2$$

$X_e$ est en fait proportionnel au carré de la composante selon l'axe des abscisses.

On ajoute à $e_1(t)$ un déphasage de $\Pi/2$ pour obtenir $e_2(t)$ et on fait le produit de ce nouveau signal par $e_1(t)$ :

$$e_1(t) \cdot e_2(t) = V^2 (\cos wt \cdot \cos (wt + \frac{\Pi}{2}))$$
$$= V^2 (\cos (2wt + \frac{\Pi}{2}) + \cos \frac{\Pi}{2})$$

Après filtrage passe-bas, il reste :

$$Y_e = 0$$

En réalisant les mêmes produits sur le signal de sortie, on obtient :

$$S(t) \cdot e_1(t) = (GV^2/2) (\cos (2 wt + \phi) + \cos \phi)$$

soit, après filtrage :

$$X_S = (GV^2/2) \cos \phi,$$

et :

$$S(t) \cdot e_2(t) = (GV^2/2) (\cos (2 wt + \phi + \Pi/2) + \cos (\Pi/2 - \phi))$$

soit, après filtrage :

$$Y_S = (GV^2/2) \sin \phi$$

Au coefficient (V/2) près, on voit que :

$$X_e = V \qquad Y_e = 0$$

$$X_S = GV \cos \phi \qquad Y_S = GV \sin \phi$$

Si l'on applique maintenant ce principe au dispositif de prédistorsion des figures 4a, 4b, 4c et 4d, c'est-à-dire à des signaux :

$$e_1(t) = V (\cos w_1 t + \cos w_2 t)$$

et

$$e_2(t) = V (\cos (w_1 t + \frac{\Pi}{2}) + \cos (w_2 t + \frac{\Pi}{2})),$$

avec le signal de sortie S(t) tel que défini précédemment par la formule (1), et atténué au moyen d'un atténuateur de fonction de transfert β, tous calculs faits, après multiplication et filtrage passe-bas, on obtient :

$$(2) \quad X_e = V^2 (1 + \cos (w_2 - w_1)t)$$

$$(3) \quad Y_e = \frac{V^2}{2} (\cos ((w_2 - w_1)t + \frac{\Pi}{2}) + \cos ((w_1 - w_2)t + \frac{\Pi}{2})) = 0$$

$$(4) \quad X_S = \beta V \left[ \begin{array}{l} (aV + \frac{9cV^3}{4} + \frac{50eV^5}{8}) \\ + (aV + 3cV^3 + \frac{75eV^5}{8}) \cos (w_2 - w_1)t \\ + (\frac{3}{4} cV^3 + \frac{30}{8} e V^5) \quad \cos 2 (w_2 - w_1)t \\ + \frac{5}{8} e V^5 \quad \cos 3 (w_2 - w_1)t \end{array} \right]$$

$$(5) \quad Y_S = \beta V \left[ \begin{array}{l} (a'V + \frac{9c'V^3}{4} + \frac{50e'V^5}{8}) \\ + (a'V + 3c'V^3 + \frac{75e'V^5}{8}) \cos (w_2 - w_1)t \\ + (\frac{3}{4} c'V^3 + \frac{30}{8} e'V^5) \quad \cos 2 (w_2 - w_1)t \\ + \frac{5}{8} e'V^5 \quad \cos 3 (w_2 - w_1)t \end{array} \right]$$

On observe sur ces signaux des termes continus, et des termes basse fréquence harmoniques de l'écart de fréquence entre les deux tons initiaux. Ces signaux ont respectivement des amplitudes qui sont la combinaison pour $X_S$ des diverses parties réelles des coefficients de non-linéarité de l'amplificateur à corriger et pour $Y_S$ des diverses parties imaginaires de ces mêmes coefficients de non-linéarité. Ces coefficients sont représentés ici pour des non-linéarités ne dépassant pas l'ordre 5. En réalité ils vont au-delà ; on peut prévoir en conséquence la fréquence de coupure des filtres passe-bas utilisés à la suite des multiplieurs.

Avec les grandeurs $X_e$, $Y_e$ caractérisant le signal d'entrée et les grandeurs homologues $X_S$, $Y_S$ caractérisant le signal de sortie, il va être possible de réaliser deux boucles d'asservissement indépendantes. Elles vont utiliser respectivement $X_e$ et $Y_e$ (égal à 0) comme information de consigne et respectivement $X_S$ et $Y_S$ comme information de contre-réaction. Les asservissements tendant à annuler la différence entre $X_S$ et $X_e$ d'une part, et entre $Y_S$ et 0 d'autre part, le signal de sortie sera le plus semblable possible au signal d'entrée. Les éléments comparatifs de ces deux boucles sont réalisés au moyen d'amplificateurs différentiels dont les gains définissent la précision de la correction tandis que les deux éléments actifs de modulation sont intégrés dans le dispositif de prédistorsion. Les signaux d'erreur q(t) et q'(t) sont fonction de la différence entre les informations de consigne et de contre-réaction.

Comme le montre la figure 7, le signal d'erreur q(t) est obtenu en sortie d'un amplificateur différentiel 23 qui reçoit sur ses deux entrées les informations de consigne $X_e$ et de contre-réaction $X_S$ relatives à l'asservissement de la composante de S(t) provenant de la partie réelle de la fonction de transfert de l'amplificateur.

Pour obtenir l'information de consigne $X_e$, il est prévu un multiplieur 24 qui reçoit sur ses deux entrées le signal $e_1(t)$ obtenu sur la sortie non déphasée du circuit 4', et un filtre passe-bas 25 disposé en sortie du multiplieur 24.

De même, pour obtenir l'information de contre-réaction $X_S$ il est prévu un multiplieur 26 qui reçoit sur ses deux entrées respectivement le signal $e_1(t)$ et le signal S(t) atténué à travers un atténuateur 27 de fonction de transfert β, et un filtre passe-bas 28 disposé en sortie du multiplieur 26.

Le signal d'erreur q'(t) est obtenu en sortie d'un amplificateur différentiel 29 qui reçoit sur ses deux entrées les informations de consigne $Y_e$ (égale à 0) et de contre-réaction $Y_S$ relatives à l'asservissement de la composante de S(t) provenant de la partie imaginaire de la fonction de transfert de l'amplificateur. Pour obtenir l'information de contre-réaction $Y_S$ il est prévu un multiplieur 30 qui reçoit sur ses deux entrées respectivement le signal $e_2(t)$ et le signal S(t), et un filtre passe-bas 31 disposé en sortie du multiplieur 30.

Les filtres passe-bas conservent les harmoniques $n(w_2 - w_1)$, avec n entier supérieur ou égal à 1. A titre d'exemple, dans le cas d'une amplification dans la bande 1,5-30 MHz, la fréquence de coupure des filtres passe-bas pourra être choisie égale à 50 kHz.

Bien que les moyens pour obtenir les signaux de correction q(t) et q'(t) conformément à l'invention puissent être utilisés avec un dispositif de prédistorsion autre que celui qui fait l'objet de la présente invention, on remarque sur la figure 7 que dans le cas où ils sont associés au dispositif de prédistorsion selon l'invention, le déphaseur 4' de $\Pi/2$ peut être commun au dispositif de prédistorsion et aux moyens d'obtention des signaux q(t) et q'(t), ce qui simplifie la mise en œuvre du dispositif de linéarisation.

En reprenant le cas d'un signal à un seul ton, pour lequel :

$$X_e = V^2/2 \qquad Y_e = 0$$

$$X_S = (GV^2/2) \cos \phi \qquad Y_S = (GV/2) \sin \phi,$$

à l'équilibre des deux boucles on a :

$X_e = X_S$, c'est-à-dire :

$V^2/2 = (\beta GV^2/2) \cos \phi$, ou encore :

$$V = \beta GV \cos \phi$$

et $\quad Y_e - Y_S$, c'est-à-dire :

$0 = \beta GV \sin \phi$, ou encore :

$$\sin \phi = 0$$

A l'équilibre des deux boucles, on a donc, pour un signal à un seul ton :

$$G = 1/\beta$$

$$\phi = 0$$

Dans le cas d'un signal deux tons, l'équilibre des deux boucles se traduit par l'identité des termes de même pulsation, d'une part dans les expressions de $X_e$ et $X_S$ (formules (2) et (4) envisagées précédemment), d'autre part dans les expressions de $Y_e$ et $Y_S$ (formules (3) et (5)).

L'égalité $Y_S = Y_e$ se traduit par :

$$\beta V \left( a'V + \frac{9c'V^3}{4} + \frac{50e'V^5}{8} \right) = 0$$

$$\beta V \left( a'V + 3c'V^3 + \frac{75e'V^5}{8} \right) = 0$$

$$\beta V \left( \frac{3}{4} c'V^3 + \frac{30}{8} e'V^5 \right) = 0$$

$$\beta V \left( \frac{5}{8} e'V^5 \right) = 0$$

$\beta$ et V étant non nuls, on en déduit les termes a', c', e' équivalents avec asservissement :

e' = 0, signifiant que l'intermodulation d'ordre 5, déphasée de $\Pi/2$, de la formule (1) est nulle.

c' = 0, signifiant que l'intermodulation d'ordre 3, déphasée de $\Pi/2$, de la formule (1) est nulle.

a' = 0, signifiant que les composantes principales, déphasées de $\Pi/2$, de la formule (1), sont nulles.

De même l'égalité $X_S = X_e$ se traduit par :

$$\beta V \left( aV + \frac{9c}{4} V^3 + \frac{50eV^5}{8} \right) = V^2$$

$$\beta V \left( aV + 3cV^3 + \frac{75eV^5}{8} \right) = V^2$$

$$\beta V \ (\frac{3}{4} \ cV^3 + \frac{30}{8} \ eV^5 \ ) = 0$$

$$\beta V \ (\frac{5}{8} \ eV^5 \ ) = 0$$

De même que précédemment, on en déduit les termes a, c, e équivalents avec asservissement :

e = 0, signifiant que l'intermodulation d'ordre 5, non déphasée, de la formule (1) est nulle.

c = 0, signifiant que l'intermodulation d'ordre 3, non déphasée, de la formule (1) est nulle.

$a \simeq 1/\beta$, représentant le gain du système sur les raies principales.

Il apparaît donc que le système se comporte comme un asservissement classique sur le signal HF dans lequel l'amplificateur de gain G non linéaire serait contre-réactionné avec un taux linéaire (atténuateur). Alors le gain équivalent vaut :

$$S(t)/e(t) = 1/\beta \ .$$

Il s'agit d'une formule classique dans les asservissements, à condition que G.g soit très supérieur à 1 (g représentant le gain des amplificateurs différentiels). C'est bien cette hypothèse que nous avons retenue puisqu'à l'entrée de l'amplificateur différentiel nous avons considéré qu'à l'équilibre les deux signaux présentaient un écart nul ; cela sous-entend que g est grand pour maintenir le signal d'erreur (q et q').

Dans la pratique, un certain temps de transit $\tau$ peut exister dans les divers éléments de la chaîne HF et produire un déphasage $\theta = w\tau$ variable avec la pulsation w.

Dans ces conditions :

$$(6) \quad \begin{cases} S(t) = (aV + \frac{9c}{4} V^3 + \frac{50eV^5}{8})(\cos(w_1 t + \theta) + \cos(w_2 t + \theta)) \\[2mm] + (a'V + \frac{9c'}{4} V^3 + \frac{50e'V^5}{8})(\cos(w_1 t + \frac{\pi}{2} + \theta) + \cos(w_2 t + \frac{\pi}{2} + \theta)) \\[2mm] + (\frac{3}{4} cV^3 + \frac{25}{8} eV^5)(\cos((2w_1 - w_2)t + \theta) + \cos((2w_2 - w_1)t + \theta)) \\[2mm] + (\frac{3}{4} c'V^3 + \frac{25}{8} e'V^5)(\cos((2w_1 - w_2)t + \theta + \frac{\pi}{2}) + \cos((2w_2 - w_1)t + \theta + \frac{\pi}{2})) \\[2mm] + \frac{5e}{8} V^5 \quad (\cos((3w_1 - 2w_2)t + \theta) + \cos((3w_2 - 2w_1)t + \theta)) \\[2mm] + \frac{5e'}{8} V^5 \quad (\cos((3w_1 - 2w_2)t + \theta + \frac{\pi}{2}) + \cos((3w_2 - 2w_1)t + \theta + \frac{\pi}{2})) \end{cases}$$

Avec $e_1(t) = V(\cos w_1 t + \cos w_2 t)$ on a alors :

$$(7) \quad X_S = e_1(t) \cdot \beta S(t) = $$
$$\beta V \begin{cases} (aV + \frac{9cV^3}{4} + \frac{50eV^5}{8})\cos\theta - (a'V + \frac{9c'V^3}{4} + \frac{50e'V^5}{8})\sin\theta \\[2mm] + ((aV + 3cV^3 + \frac{75}{8} eV^5)\cos\theta - (a'V + 3c'V^3 + \frac{75}{8}e'V^5)\sin\theta)\ \cos(w_2 - w_1)t \\[2mm] + ((\frac{3}{4} cV^3 + \frac{30}{8}eV^5)\cos\theta - (\frac{3}{4} e'V^3 + \frac{30}{8}e'V^5)\sin\theta)\ \cos 2(w_2 - w_1)t \\[2mm] + (\frac{5}{8} eV^5 \cos\theta - \frac{5}{8} e'V^5 \sin\theta)\ \cos 3(w_2 - w_1)t \end{cases}$$

Et avec

$$e_2(t) = V(\cos(w_1 t + \frac{\pi}{2}) + \cos(w_2 t + \frac{\pi}{2})),$$

on a :

$$(8) \quad Y_S = e_2(\tau) \cdot \beta S(t) = $$
$$\beta V \begin{cases} (aV + \frac{9cV^3}{4} + \frac{50eV^5}{8})\sin\theta + (a'V + \frac{9c'V^3}{4} + \frac{50e'V^5}{8})\cos\theta \\[2mm] + ((aV + 3cV^3 + \frac{75}{8} eV^5)\sin\theta + (a'V + 3c'V^3 + \frac{75}{8} e'V^5)\cos\theta)\ \cos(w_2 - w_1)t \\[2mm] + ((\frac{3}{4} cV^3 + \frac{30}{8} eV^5)\sin\theta + (\frac{3}{4} e'V^3 + \frac{30}{8}e'V^5)\cos\theta)\ \cos 2(w_2 - w_1)t \\[2mm] + (\frac{5}{8} eV^5 \sin\theta + \frac{5}{8} e'V^5 \cos\theta)\ \cos 3(w_2 - w_1)t \end{cases}$$

11

Chaque terme est cette fois composé de deux parties dont le terme parasite, pondéré par la valeur de sin θ , est d'autant plus gênant que θ est grand.

Ainsi le système se stabilise mais il y a interdépendance de l'action d'une boucle sur la correction de l'autre et vice versa. On évitera cette difficulté en plaçant un circuit de retard permettant de ramener θ à une valeur nulle, soit sur les sorties $e_1(t)$ et $e_2(t)$ dans la direction des multiplieurs, en plaçant deux lignes à retard 32 et 33 de valeur τ, soit en plaçant dans le retour β une ligne 34 à retard (T-τ) mais celui-ci varie avec la fréquence, ce qui est moins commode (la ligne à retard 34 étant représentée en pointillés sur la figure 7).

Comme on l'a représenté en traits pointillés sur la figure 7, l'atténuateur 27 peut être remplacé par un atténuateur variable 37, commandé par exemple par une mémoire programmée 38, dans le but de compenser le gain de l'amplificateur à linéariser, afin de conserver constant le point de fonctionnement du dispositif de prédistorsion 1.

Dans le cas de la figure 7, l'information de sortie S(t) est prélevée après filtrage harmonique. On peut cependant prendre S(t) avant filtrage, car les harmoniques multipliées par $e_1(t)$ et $e_2(t)$ (dans les multiplieurs 26 et 30) donnent des termes HF qui sont éliminés par les filtres passe-bas 28 et 31. Si l'information de sortie est prélevée après le filtre harmonique 13 celui-ci apporte un déphasage très gênant s'ajoutant au temps de transit. On peut alors réaliser deux filtres 35 et 36 de fonction et de structure identiques, sauf la puissance (seule la fonction déphasage nous intéresse) et les placer en série avec les lignes à retard 32 et 33. Il y a ainsi bonne compension de phase entre les signaux arrivant aux multiplieurs 26 et 30.

On a vu que pour un signal d'entrée à un ton ou à deux tons égaux, le gain équivalent avait pour valeur linéaire l'inverse du coefficient de contre-réaction β.

On envisage maintenant le cas d'un signal d'entrée à deux tons inégaux $e(t) = V_1 \cos w_1 t + V_2 \cos w_2 t$.

On a alors :

$$X_e = \frac{V_1^2}{2} + \frac{V_2^2}{2} + V_1 V_2 \cos (w_2 - w_1)t$$

$$S(t) =$$

$$(a V_1 + \frac{3}{4} c(V_1^3 + 2V_1 V_2^2) + \frac{5}{8} e(V_1^5 + 6V_1^3 V_2^2 + 3V_1 V_2^4)) \cos w_1 t$$

$$+ (a V_2 + \frac{3}{4} c(V_2^3 + 2V_2 V_1^2) + \frac{5}{8} e(V_2^5 + 6V_2^3 V_1^2 + 3V_2 V_1^4)) \cos w_2 t$$

$$+ (a' V_1 + \frac{3}{4} c'(V_1^3 + 2V_1 V_2^2) + \frac{5}{8} e'(V_1^5 + 6V_1^3 V_2^2 + 3V_1 V_2^4)) \cos(w_1 t + \frac{\pi}{2})$$

$$+ (a' V_2 + \frac{3}{4} c'(V_2^3 + 2V_2 V_1^2) + \frac{5}{8} e'(V_2^5 + 6V_2^3 V_1^2 + 3V_2 V_1^4)) \cos(w_2 t + \frac{\pi}{2})$$

$$+ (\frac{3}{4} c V_1^2 V_2 + \frac{5}{8} e(2V_1^4 V_2 + 3V_1^2 V_2^3)) \quad \cos(2w_1 - w_2)t$$

$$+ (\frac{3}{4} c V_2^2 V_1 + \frac{5}{8} e(2V_2^4 V_1 + 3V_2^2 V_1^3)) \quad \cos(2w_2 - w_1)t$$

$$+ (\frac{3}{4} c' V_1^2 V_2 + \frac{5}{8} e'(2V_1^4 V_2 + 3V_1^2 V_2^3)) \quad \cos ((2w_1 - w_2)t + \frac{\pi}{2})$$

$$+ (\frac{3}{4} c' V_2^2 V_1 + \frac{5}{8} e'(2V_2^4 V_1 + 3V_2^2 V_1^3)) \quad \cos ((2w_2 - w_1)t + \frac{\pi}{2})$$

$$+ \frac{5}{8} e V_1^3 V_2^2 \qquad\qquad \cos(3w_1 - 2w_2)t$$

$$+ \frac{5}{8} e V_2^3 V_1^2 \qquad\qquad \cos(3w_2 - 2w_1)t$$

$$+ \frac{5}{8} e' V_1^3 V_2^2 \qquad\qquad \cos ((3w_1 - 2w_2)t + \frac{\pi}{2})$$

$$+ \frac{5}{8} e' V_2^3 V_1^2 \qquad\qquad \cos ((3w_2 - 2w_1)t + \frac{\pi}{2})$$

On ne développe pas ici les calculs de $X_S$ et $Y_S$ mais comme précédemment, l'égalité entre $Y_S$ et $Y_e$ (= 0) annule tous les termes imaginaires de non-linéarité en boucle fermée. De même l'égalité entre $X_S$ et $X_e$ annule les coefficients autres que « a » en boucle fermée.

On peut quand même développer les premiers termes de $X_S$ :

$$X_S =$$

$$\frac{\beta}{2}\left((aV_1 + \frac{3}{4}c(V_1^3 + 2V_1V_2^2) + \frac{5}{8}e(V_1^5 + 6V_1^3V_2^2 + 3V_1V_2^4))V_1\right.$$

$$+ \frac{\beta}{2}\left((aV_2 + \frac{3}{4}c(V_2^3 + 2V_2V_1^2) + \frac{5}{8}e(V_2^5 + 6V_2^3V_1^2 + 3V_2V_1^4))V_2\right.$$

$$+ \frac{\beta}{2}\left[\begin{array}{l}(\varepsilon V_1 + \frac{3}{4}cV_1^3 + 2V_1V_2^2) + \frac{5}{8}e(V_1^5 + 6V_1^3V_2^2 + 3V_1V_2^4) \\ + \frac{3}{4}cV_2^2V_1 + \frac{5}{8}e(2V_2^4V_1 + 3V_2^2V_1^3)\end{array}\right] V_2\cos(w_2-w_1)t$$

$$+ \frac{\beta}{2}\left[\begin{array}{l}(aV_2 + \frac{3}{4}cV_2^3 + 2V_2V_1^2) + \frac{5}{8}e(V_2^5 + 6V_2^3V_1^2 + 3V_2V_1^4) \\ + \frac{3}{4}cV_1^2V_2 + \frac{5}{8}e(2V_1^4V_2 + 3V_1^2V_2^3)\end{array}\right] V_1\cos(w_2-w_1)t$$

$$+ \ldots \text{etc}$$

Comme on l'a vu, les termes équivalents en boucle fermée e, c, e', c', a' sont annulés par l'égalité à l'entrée des comparateurs.

En boucle fermée, $X_S$ et $X_e$ deviennent :

$$X_S = \frac{\beta}{2}(aV_1^2 + aV_2^2) + 2aV_1V_2\cos(w_2-w_1)t$$
$$X_e = \frac{1}{2}(V_1^2 + V_2^2) + V_1V_2\cos(w_2-w_1)t$$

En comparant $X_e$ et $X_S$ on trouve finalement :

$$(V_1^2 + V_2^2)/2 = (\beta/2)(aV_1^2 + aV_2^2)$$

pour les termes continus et $V_1V_2 = 2aV_1V_2$ pour les termes de pulsation $w_2 - w_1$. D'où (en boucle fermée à l'équilibre) $a = 1/\beta$. La même solution apparaît si on prend un signal d'entrée à n tons. Donc à condition de respecter la condition de phase entre e(t) et S(t) la plus voisine possible de zéro, on a dans tous les cas :

$$S(t) \simeq (1/\beta)\, e(t)$$

($\beta$ étant la fonction de transfert d'un atténuateur très linéaire).

**Revendications**

1. Dispositif de linéarisation d'amplificateur (12) de signaux haute fréquence, à coefficients de non-linéarité complexes, et destiné à amplifier un signal multitons e(t), comportant des moyens pour élaborer, à partir du signal haute fréquence à amplifier, un premier et un second signal de correction q(t) et q'(t) dont le spectre comporte des raies d'amplitude réglable situées à des fréquences correspondant aux harmoniques des écarts de tons du signal haute fréquence à amplifier, agissant séparément sur deux paramètres distincts du signal à amplifier, et un dispositif de prédistorsion (1) pour élaborer à partir du signal haute fréquence à amplifier et des premier et second signaux de correction un signal d'entrée h(t) de l'amplificateur dont le spectre comporte, outre les raies haute fréquence du signal à amplifier, des raies correctrices, aux fréquences des produits d'intermodulation d'ordres impairs, d'amplitude réglable par action conjointe sur les réglages d'amplitude des raies du spectre du premier et du second signal de correction q(t) et q'(t), ces réglages étant effectués en vue d'obtenir une annulation des produits d'intermodulation d'ordres impairs situés au voisinage de la bande d'émission dans le signal amplifié, caractérisé en ce que le dispositif de prédistorsion (1) comporte un modulateur d'amplitude (2) du signal à amplifier e(t) par le premier signal de correction q(t), un modulateur d'amplitude à suppression de porteuse (3), du signal à amplifier e(t) déphasé de Π/2 par le second signal de correction q'(t), et un sommateur (5) des signaux issus de ces deux modulateurs, fournissant le signal d'entrée de l'amplificateur (12).

2. Dispositif selon la revendication 1, caractérisé en ce que le dispositif de prédistorsion (1) comporte un modulateur d'amplitude (2) du signal à amplifier e(t) par le premier signal de correction q(t), un modulateur d'amplitude à suppression de porteuse (3) du signal à amplifier e(t) par le second signal de correction q'(t), et un coupleur en quadrature (5') des signaux issus de ces deux modulateurs, fournissant le signal d'entrée de l'amplificateur (12).

3. Dispositif selon l'une des revendications 1 et 2, caractérisé en ce que le premier et le second signal de correction, q(t) et q'(t), sont obtenus respectivement par asservissement de l'amplitude de deux composantes orthogonales X et Y du signal amplifié (atténué), provenant respectivement de la partie réelle et de la partie imaginaire de la fonction de transfert de l'amplificateur à linéariser, aux composantes correspondantes du signal à amplifier.

4. Dispositif de linéarisation selon la revendication 3, caractérisé en ce que l'information de consigne $X_e$ relative à l'asservissement sur le paramètre X est obtenue au moyen d'un multiplieur (24) qui reçoit sur ses deux entrées le signal à amplifier e(t), suivi d'un filtre passe-bas (25).

5. Dispositif de linéarisation selon l'une des revendications 3 et 4, caractérisé en ce que l'information de contre-réaction $X_S$ relative à l'asservissement sur le paramètre X est obtenue au moyen d'un multiplieur (26) qui reçoit le signal à amplifier e(t) et le signal amplifié atténué βS(t), suivi d'un filtre passe-bas (28).

6. Dispositif selon l'une des revendications 3, 4 et 5, caractérisé en ce que l'information de consigne $Y_e$ relative à l'asservissement sur le paramètre Y est nulle.

7. Dispositif selon l'une des revendications 3, 4, 5, 6 caractérisé en ce que l'information de contre-réaction $Y_s$ relative à l'asservissement sur le paramètre Y est obtenue au moyen d'un multiplieur (30) qui reçoit le signal à amplifier e(t), déphasé de Π/2, et le signal amplifié atténué βS(t), suivi d'un filtre passe-bas (31).

8. Dispositif selon l'une des revendications 3 à 7, caractérisé en ce que les moyens pour obtenir les signaux de correction q(t) et q'(t) comportent des lignes à retard (32, 33) pour compenser le déphasage du signal amplifié (atténué) par rapport au signal à amplifier.

9. Dispositif selon l'une des revendications 3 à 7, caractérisé en ce que l'atténuation β du signal de sortie de l'amplificateur (12), préalable à l'élaboration des informations de contre-réaction, est commandée de manière à maintenir constant le point de fonctionnement du dispositif de prédistorsion.

10. Dispositif selon la revendication 9, caractérisé en ce que cette commande est réalisée au moyen d'une mémoire programmée (38) commandant un atténuateur variable (37).

11. Dispositif selon les revendications 1 et 7, caractérisé en ce que les déphasages de Π/2 sont réalisés par le même élément.

## Claims

1. Linearizing device of a high frequency signal amplifier (12), having complex non-linearity coefficients and susceptible to amplify a multi-tone signal e(t), comprising means to generate from the high frequency signal to be amplified a first and a second correction signal q(t) and q'(t) the spectrum of which comprises lines of adjustable amplitude lying at frequencies corresponding to harmonics of the tone spacings of the high frequency signal to be amplified, separately acting on two distinct parameters of the signal to be amplified, and a predistortion device (1) to generate from the high frequency signal to be amplified and from the first and second correction signals an input signal h(t) of the amplifier the spectrum of which comprises, in addition to the high frequency lines of the signal to be amplified, correcting lines at the frequencies of the intermodulation products of odd orders, the amplitude of which is adjustable by the combined action on the amplitude adjustments of the lines of the spectrum of the first and second correction signals q(t) and q'(t), these adjustments being performed in order to obtain an elimination of the intermodulation products of odd orders located in the neighborhood of the transmission band in the amplified signal, characterized in that the predistortion device (1) comprises a modulator (2) for modulating the amplitude of the signal to be amplified e(t) by the first correction signal q(t), a suppressed carrier modulator (3) for modulating the signal to be amplified e(t) phase shifted by $\pi/2$ by the second correction signal q'(t), and a summer (5) for summing the signals supplied by these modulators to furnish the input signal of the amplifier (12).

2. Device according to claim 1, characterized in that the predistortion device (1) comprises a modulator (2) for modulating the amplitude of the signal to be amplified e(t) by the first correction signal q(t), a suppressed carrier modulator (3) for modulating the amplitude of the signal to be amplified e(t) by the second correction signal q'(t), and a quadrature coupler (5') for coupling the signals supplied by these two modulators to furnish the input signal of the amplifier (12).

3. Device according to any of claims 1 and 2, characterized in that the first and second correction signals q(t) and q'(t) are respectively obtained by controlling the amplitude of the two orthogonal components X and Y of the amplified (attenuated) signal respectively originating from the real part and the imaginary part of the transfer function of the amplifier to be linearized, by the corresponding components of the signal to be amplified.

4. Linearizing device according to claim 3, characterized in that the set value information $x_e$ relating to the control by the parameter X is obtained by means of a multiplier (24) receiving on its two inputs the signal to be amplified e(t), followed by a low-pass filter (25).

5. Linearizing device according to any of claims 3 and 4, characterized in that the negative feedback information $X_S$ relating to the control by the parameter X is obtained by means of a multiplier (26) which receives the signal to be amplified e(t) and the amplified attenuated signal βS(t), followed by a low-pass filter (28).

6. Device according to any of claims 3, 4 and 4, characterized in that the set value information $Y_e$ relating to the control by the parameter Y is zero.

7. Device according to any of claims 3, 4, 5, 6, characterized in taht the negative feedback information $Y_s$ relating to the control by the parameter Y is obtained by means of a multiplier (30) which receives the signal to be amplified e(t) phase shifted by π/2 and the amplified attenuated signal βS(t), followed by a low-pass filter (31).

8. Device according to any of claims 3 to 7, characterized in that the means for obtaining the correction signals q(t) and q'(t) comprise delay lines (32, 33) to compensate for the phase shift of the amplified (attenuated) signal with respect to the signal to be amplified.

9. Device according to any of claims 3 to 7, characterized in that the attenuation of the output signal of the amplifier (12), prior to the generation of the negative feedback information, is controlled in a manner to maintain constant the operating point of the predistortion device.

10. Device according to claim 9, characterized in that this control is performed by means of a programmed memory (38) controlling a variable attenuator (37).

11. Device according to claims 1 and 7, characterized in that the phase shifts of π/2 are obtained by the same element.


**Patentansprüche**

1. Linearisiervorrichtung eines Verstärkers (12) für Hochfrequenzsignale, mit komplexen Nichtlinearitätskoeffizienten, zur Verstärkung eines Mehrtonsignals e(t), mit Einrichtungen, um aus dem zu verstärkenden Hochfrequenzsignal ein erstes sowie ein zweites Korrektursignal q(t) und q'(t) zu erzeugen, deren Spektrum Linien einstellbarer Amplitude enthält, die bei Frequenzen liegen, welche den Harmonischen der Tonabstände des zu verstärkenden Hochfrequenzsignals entsprechen, die getrennt auf zwei verschiedene Parameter des zu verstärkenden Signals einwirken, und mit einer Vorverzerrvorrichtung (1), um aus dem zu verstärkenden Hochfrequenzsignal und aus dem ersten sowie dem zweiten Korrektursignal ein Eingangssignal h(t) des Verstärkers zu erzeugen, dessen Spektrum außer den Hochfrequenzlinien des zu verstärkenden Signals Korrekturlinien bei den Frequenzen der Intermodulationsprodukte ungeradzahliger Ordnung enthält, deren Amplitude durch gemeinsame Einwirkung auf die Amplitudeneinstellungen der Linien des Spektrums der ersten und des zweiten Korrektursignals q(t) und q'(t) einstellbar ist, wobei diese Einstellungen erfolgen, um eine Beseitigung der Intermodulationsprodukte ungerader Ordnungszahl zu erhalten, welche in der Nähe des Sendebandes in dem verstärkten Signal liegen, dadurch gekennzeichnet, daß die Vorverzerrvorrichtung (1) einen Modulator (2) zum Modulieren der Amplitude des zu verstärkenden Signals e(t) durch das erste Korrektursignal q(t), einen mit Unterdrückung der Trägerschwingung arbeitenden Modulator (3) zum Modulieren des zu verstärkenden Signals e(t), das um π/2 phasenverschoben ist, durch das zweite Korrektursignal q'(t) und einen Summierer (5) enthält, welcher die von diesen beiden Modulatoren abgegebenen Signale summiert und das Eingangssignal des Verstärkers (12) liefert.

2. Vorrichtung nach Anspruch 1, dadurch gekennzeichnet, daß die Vorverzerrvorrichtung (1) einen Modulator (2) zum Modulieren der Amplitude des zu verstärkenden Signals e(t) durch das erste Korrektursignal q(t), einen mit Trägerunterdrückung arbeitenden Modulator (3) zum Modulieren des zu verstärkenden Signals e(t) durch das zweite Korrektursignal q'(t) und einen Koppler (5') zum Koppeln der von diesen beiden Modulatoren abgegebenen Signale unter einer 90°-Phasenverschiebung, welcher das Eingangssignal des Verstärkers (12) liefert, umfaßt.

3. Vorrichtung nach Anspruch 1 oder 2, dadurch gekennzeichnet, daß das erste und das zweite Korrektursignal q(t) und q'(t) jeweils durch Amplitudenregelung von zwei orthogonalen Komponenten X und Y des verstärkten (gedämpften) Signals, die vom Realteil bzw. Imaginärteil der Übertragungsfunktion des zu linearisierenden Verstärkers herrühren, durch die entsprechenden Komponenten des zu verstärkenden Signals erhalten werden.

4. Linearisierungsvorrichtung nach Anspruch 3, dadurch gekennzeichnet, daß die Sollwertinformation $X_e$ für die Nachregelung nach dem Parameter X mittels eines Multiplizierers (24) erhalten wird, welcher an seinen zwei Eingängen das zu verstärkende Signal e(t) empfängt, gefolgt von einem Tiefpaßfilter (25).

5. Linearisierungsvorrichtung nach einem der Ansprüche 3 und 4, dadurch gekennzeichnet, daß die

Rückkopplungsinformation $X_S$ für die Nachregelung nach dem Parameter X mittels eines Multiplizierers (26) erhalten wird, der das zu verstärkende Signal e(t) und das verstärkte gedämpfte Signal $\beta$S(t) empfängt, gefolgt von einem Tiefpaßfilter (28).

6. Vorrichtung nach einem der Ansprüche 3, 4 und 5, dadurch gekennzeichnet, daß die Sollwertinformation $Y_e$ für die Nachregelung nach dem Parameter Y gleich Null ist.

7. Vorrichtung nach einem der Ansprüche 3, 4, 5, 6, dadurch gekennzeichnet, daß die Rückkopplungsinformation $Y_S$ für die Nachregelung nach dem Parameter Y mittels eines Multiplizierers (30) erhalten wird, welcher das zu verstärkende Signal e(t) um $\pi/2$ phasenverschoben und das verstärkte gedämpfte Signal $\beta$S(t) empfängt, gefolgt von einem Tiefpaßfilter (31).

8. Vorrichtung nach einem der Ansprüche 3 bis 7, dadurch gekennzeichnet, daß die Mittel zum Erhalten der Korrektursignale q(t) und q'(t) Verzögerungsleitungen (32, 33) zum Kompensieren der Phasenverschiebung des verstärkten (gedämpften) Signals bezüglich des zu verstärkenden Signals umfassen.

9. Vorrichtung nach einem der Ansprüche 3 bis 7, dadurch gekennzeichnet, daß die Dämpfung $\beta$ des Ausgangssignals des Verstärkers (12), welche der Erzeugung der Rückkopplungsinformationen vorausgeht, in solcher Weise gesteuert wird, daß der Arbeitspunkt der Vorverzerrungsvorrichtung konstant gehalten wird.

10. Vorrichtung nach Anspruch 9, dadurch gekennzeichnet, daß diese Steuerung mittels eines programmierten Speichers (38) erfolgt, der ein variables Dämpfungsglied (37) steuert.

11. Vorrichtung nach den Ansprüchen 1 und 7, dadurch gekennzeichnet, daß die $\pi/2$-Phasenverschiebungen durch dasselbe Element verursacht werden.

$X(e(t))$

$e(t)$

Fig.1a

$Y(e(t))$

$e(t)$

Fig.1b

$|S(t)|$

$e(t)$

Fig.1c

$\varphi$

$e(t)$

Fig.1d

$e(t)$

$t$

Fig.2

$S(t)$

$A+\dfrac{9c}{4}$

$\dfrac{3c}{4}$

$B$

$B$

$B/2$

$\dfrac{3c}{4}$

$\dfrac{c}{4}$

$\omega_2-\omega_1$   $2\omega_1-\omega_2$   $\omega_1$   $\omega_2$   $2\omega_2-\omega_1$   $2\omega_1$   $\omega_1+\omega_2$   $2\omega_2$   $3\omega_1$   $2\omega_1+\omega_2$   $2\omega_2+\omega_1$   $3\omega_2$   $\omega$

Fig.3 a

$S(t)$

$A+\dfrac{9c}{4}$

$\dfrac{3c}{4}$

$2\omega_1-\omega_2$   $\omega_1$   $\omega_2$   $2\omega_2-\omega_1$   $\omega$

Fig.3 b

1

Fig.4a

Fig.4b

Fig.4d

Fig.4c

Fig.5

0 121 446

Fig.6

0 121 446

$S(t)$

FILTRE HARMONIQUE — 13

12 — AMPLIFICATEUR HF

$h(t)$

1 — SOMMATEUR — 5

MODULATEUR D'AMPLITUDE À PORTEUSE SUPPRIMÉE — 3

MODULATEUR D'AMPLITUDE — 2

$h_1(t)$ $h_2(t)$

$q(t)$

23 — $+$ $-$

$X_e$ — FILTRE PASSE-BAS — 25

$X_s$ — FILTRE PASSE-BAS — 28

MULTIPLIEUR — 24

MULTIPLIEUR — 26

$q'(t)$

AMPLIFICATEURS DIFFÉRENTIELS — 29 — $+$ $-$

$Y_s$ — FILTRE PASSE-BAS — 31 — $Y_e=0$

MULTIPLIEUR — 30

LIGNE À RETARD — 34

ATTÉNUATEUR — 27

ATTÉNUATEUR VARIABLE — 37

MÉMOIRE PROGRAMMÉE — 38

$\beta S(t)$

$e_1(t)$

DÉPHASEUR DE $\frac{\pi}{2}$ — 4'

$e_2(t)$

LIGNE À RETARD — 32 — FILTRE — 35

LIGNE À RETARD — 33 — FILTRE — 36

$e(t)$

Fig.7